# EUROPEAN PATENT APPLICATION

(11) **EP 2 894 680 A1**
(43) Date of publication of application: **15.07.2015**
(21) Application number: 13835368.5
(22) Date of filing: 10.09.2013
(51) Int. Cl.: H01L 33/30, H01L 21/208

(54) **GALNASSB SOLID SOLUTION-BASED HETEROSTRUCTURE, METHOD FOR PRODUCING SAME AND LIGHT EMITTING DIODE BASED ON SAID HETEROSTRUCTURE**

(30) Priority: 07.09.2012 EA 201201243
(71) Applicant: Limited Liability Company "LED Microsensor NT", St. Petersburg 194021 (RU)
(72) Inventor: STOYANOV, Nikolay Deev, St.Petersburg 197341 (RU); ZHURTANOV, Bizhigit Erzhigitovich, St. Petersburg, 194223 (RU)
(74) Representative: Grünecker Patent- und Rechtsanwälte PartG mbB
(86) International application number: PCT/RU2013/000786
(87) International publication number: WO 2014/038986

(57) **Abstract**

The present invention relates to a field of semiconductor devices, and more particularly to a heterostructure based on a GaInAsSb solid solution with a reverse p-n junction, to a method of producing the heterostructure, and to a light emitting diode based on the heterostructure. The provided heterostructure comprises a substrate containing GaSb, an active layer which contains a GaInAsSb solid solution and which is disposed over the substrate, a confining layer for localizing major carriers which contains a AlGaAsSb solid solution and which is disposed over the active layer, a contact layer which contains GaSb and which is disposed over the confining layer, wherein the heterostructure further comprises a buffer layer which contains a GaInAsSb solid solution and which is disposed between the substrate and the active layer, the buffer layer containing indium (In) less than the active layer. Use of this buffer layer makes it possible to localize minor carriers in an active region, thereby resulting in an increased amount of radiative recombination and, therefore, an increased quantum efficiency of the heterostructure. Furthermore, use of the buffer layer makes it possible to minimize an influence of defects penetrating from the substrate into the active region, thereby resulting in reduction in deep acceptor levels and, correspondingly, in reduction in amount of non-radiative Shokley-Read-Hall recombination, and also to increased quantum efficiency of the heterostructure. Light emitting diodes produced on the basis of the provided heterostructure emit in a mid-infrared spectral range of 1.8-2.4 µm.

## Description

### FIELD OF THE INVENTION

The present invention relates to semiconductor devices, and more particularly, to a heterostructure based on a GaInAsSb solid solution having a reverse p-n junction, to a method of producing same, and to a light-emitting diode (LED) based on the provided heterostructure. When produced on the basis of the provided heterostructure, light-emitting diodes (LEDs) are emitting radiation in the mid-infrared (mid-IR) spectral range of 1.8-2.4 µm. The provided heterostructure, method of producing the heterostructure, and the LED based on the heterostructure, have substantial advantages when used for making detectors configured for gas analysis applications. In particular, the detectors may be useful for monitoring an environment and for controlling technology processes: for example for detecting carbon dioxide in a living spaces and industrial constructions or for detecting methane in constructions where natural gas is used, along gas pipelines, and in mines. Furthermore, the mid-IR detectors may be useful for determining water content in oil and petroleum products, for assessing moisture content in a paper, grain products or etc. Furthermore, mid-IR detectors may be useful for the purposes of medical diagnostics: for example, in optical spectroscopy as applied for analyzing a concentration of carbon dioxide, acetone and other substances contained in an expired air; for noninvasive controlling the content of glucose and other organic components in blood, lymph, and tissues. Having mentioned such applications, the present invention is not meant to be limited with the provided examples of use; and the heterostructure and the heterostructure-based LEDs may be found useful in any other fields that require detecting the presence and/or concentrations of substances that have the absorption bands observed in the mid-IR spectral range of 1.8-2.4 µm.

### BACKGROUND OF THE INVENTION

Known from prior art are optical infrared detectors, which are based on thermal sources of infrared radiation, produced by Perkin Elmer, Texas Instruments, City Technology, and other manufacturing companies. The thermal sources emit in a wide spectral range, and then special optical filters are applied to cut a required spectral window of wavelengths.

A drawback revealed in the prior art optical detectors is the necessity of using optical filters. Besides, the known optical detectors have other shortcomings, such as high electric power consumption, poor response time, large dimensions, and limited lifetime of thermal sources.

These disadvantages of the known thermal sources-based optical IR detectors can be met by using light-emitting diodes (LEDs) emitting in the mid-IR spectral range.

Disclosed in [Patent RU No. 2286618, IPC H01L 33/00, H01L 31/12] is a semiconductor diode for the infrared range of the spectrum, comprising p- and n-regions with conducting contacts divided with a p-n junction, an active region electrically connected to the p-n junction, and at least one optical module optically connected with the active region through an optical compound.

A drawback revealed in the known diode is the limited range of wavelengths 1.22-1.24 µm, within which the diode is capable of emitting. The wavelength of this diode is determined by the diode structure, wherein the diode comprises an n⁺-InP substrate, with an active layer disposed thereon and containing a InGaAsP solid solution. In another embodiment of the prior art, the known semiconductor diode comprises an n⁺-InAs substrate, with a double n-InAsSbP/n-InGaAs/p-InAsSbP heterostructure grown thereon. The diode emits light at a wavelength of 3.4 µm. In another embodiment, the known diode comprises an n-InAs substrate, upon which a n-InAsSbP/n-InGaAsSb/p-InAsSbP double heterostructure is grown. The diode emits light at a wavelength of 3.9 µm. Thus, using the known heterostructures does not make it possible to obtain LEDs capable of emitting in the spectral range of 1.8-2.4 µm. Hence, the prior art semiconductor diodes cannot be used for the purpose of detecting the presence and/or concentrations of substances with the characteristic absorption bands observed in the range of 1.8-2.4 µm.

Another drawback revealed in the prior art diode is the use of an optical module and an optical compound, which makes the diode producing technology more complicated and increases the probability of introducing defects at the stages of connecting the optical module with an LED chip.

Furthermore, known are LEDs of the spectral range 1.6-2,4 µm, disclosed in [N.D. Stoyanov, B. E. Zhurtanov, A.P. Astakhova, A.N, Imenkov, and Yu. P. Yakovlev. Vysokoeffektivnye svetodiody spektral'nogo diapazona 1.6 - 2.4 µm dlya meditsinskoi diagnostiki i ekologicheskogo monitoringa (Highly efficient light-emitting diodes of a spectral range 1.6 - 2.4 µm for medical diagnostics and environmental monitoring). Fizika i tekhnika poluprovodnikov (Physics and Engineering of Semiconductors), 2003, v. 37, issue 8, pp. 996-1009]. These LEDs are configured on the basis of a heterostructure which comprises a GaSb substrate, an active layer containing a GaInAsSb solid solution, a first confining layer containing a solid solution of AlGaAsSb, and a contact layer containing GaSb. In addition, the heterostructure may also comprise a second confining layer containing a AlGaAsSb solid solution.

The state-of-the-art LED has a disadvantage that its quantum yield is limited, because of the influence of defects that penetrate from the substrate into the active region, and because of the lack of barrier to the minority carriers - i.e., holes. Hole leakage from the active region prevents from having a high probability of the radiative recombination process.

In addition, the cited reference proposes use of a n-GaSb buffer layer to ensure a minimum content of defects in the active region. The buffer layer is grown on a substrate, with lead used as a neutral solvent.

The current state-of-the-art diode, which is configured on the basis of the heterostructure with a n-GaSb buffer layer, has solved the problem of defects growing from the substrate; however, the localization problem of holes to be confined within the active region still persists. Moreover, using lead in the process of growing the n-GaSb buffer layer, complicates the technology, causes damage to the environment, and is harmful to the personnel involved.

Also known from prior art is a light-emitting diode heterostructure of a thyristor type n-GaSb/p-GaSb/n-GaInAsSb/P-AlGaAsSb with a maximum radiation at a wavelength of 1.95 µm [N.D. Stoyanov, B. E. Zhurtanov, A.N, Imenkov, A.P. Astakhova, M.P. Mikhailova, and Yu. P. Yakovlev, Vysokoeffektivnye svetodiody na osnove tiristornoi geterostruktyry II tipa n-GaSb/p-GaSb/n-GaInAsSb/P-AlGaAsSb (Highly efficient light-emitting diodes based on a thyristor heterostructure of type II). Fizika i tekhnika poluprovodnikov (Physics and Engineering of Semiconductors), 2007, v. 41, issue 7, pp. 878-882]. This heterostructure is deemed to be the closest prior art to the claimed invention: it comprises a substrate containing GaSb; an active layer which contains a GaInAsSb solid solution and which is disposed over the substrate; a confining layer for localizing major carriers, the confining layer containing a AlGaAsSb solid solution and being disposed over the active layer; and a contact layer which contains GaSb and which is disposed over the confining layer. In addition, the heterostructure comprises a buffer layer containing n-GaSb grown on the substrate, and a built-in layer disposed between the buffer layer and the active layer, the built-in layer comprising p-GaSb and being configured to confine holes in the active region.

The known heterostructure has a disadvantage that is the n-GaSb buffer layer is grown from a solution-melt containing lead as a neutral solvent, using which complicates the technology, causes damage to the environment, and is harmful to the personnel involved. In addition, the current-voltage characteristic of the cited heterostructure is of shape typical for thyristor structures, which results in an increase in the operating voltage up to 2.0-2.5 V and, hence, in an increase in the consumed electric power by 4.0-4.5 times as compared with the diode heterostructure. Moreover, the cited heterostructure has inconsistent performance at high currents because of the presence of hysteresis and a high probability of the avalanche breakdown.

Therefore, even though known from prior art are a variety of heterostructures and the heterostructures-based LEDs intended for the mid-IR spectral range, there is an obvious need for heterostructures and LEDs produced thereon, which are more reliable, have a low operating voltage, possess a current-voltage characteristic enabling operation in a wide range of currents, minimize the influence of defects penetrating from the substrate into the active region, and confine holes in the active region, and which can at the same time be produced with a more simple and environmentally friendly technology of growing a buffer layer.

### SUMMARY OF THE INVENTION

A object of the claimed invention is to develop a reliable and efficient heterostructure which ensures hole confinement and prevents from defects growing from substrate and which can be produced using a lead-free technology.

Another object of the invention is to develop a method of producing the heterostructure. Another yet object of the invention is to develop an light-emitting diode (LED) on the basis of the heterostructure.

A further object of the invention is to develop a method of producing a LED based on the heterostructure.

According to the first aspect of the present invention, the object is achieved by providing a GaInAsSb solid solution-based heterostructure comprising: a substrate containing GaSb; an active layer which contains a GaInAsSb solid solution and which is disposed over the substrate; a confining layer for localizing major carriers, the confining layer containing a AlGaAsSb solid solution and being disposed over the active layer; a contact layer which contains GaSb and which is disposed over the confining layer; and further comprising a buffer layer which contains a GaInAsSb solid solution and which is disposed between the substrate and the active layer, wherein the buffer layer contains indium (In) less than the active layer.

In one of the embodiments, a mole fraction of indium (In) among the elements of the group III in the buffer layer is 1.2-1.6 %.

According to the second aspect of the present invention, the object is achieved by providing a method of producing a GaInAsSb solid solution-based heterostructure, the method including: growing, by a liquid-phase epitaxy technique, a p-type buffer layer on an n-type GaSb substrate, the buffer layer containing a GaInAsSb solid solution; growing, by a liquid-phase epitaxy technique, an n-type active layer on the buffer layer, the active layer containing a GaInAsSb solid solution, so that the active layer contains indium (In) more than the buffer layer; growing, by a liquid-phase epitaxy technique, a p-type confining layer for localizing major carriers on the active layer, the confining layer containing a AlGaAsSb solid solution; and growing, by a liquid-phase epitaxy technique, a p-type contact layer containing GaSb on the confining layer.

According to the third aspect of the present invention, the object is achieved by providing a light-emitting diode for a mid-IR spectral range, the light-emitting diode comprising: at least one LED chip which is configured on the basis of the heterostructure according to the first aspect of the present invention and which comprises a first contact configured on the active layer side and a second contact configured on the substrate side, wherein the LED chip comprises a buffer layer containing a GaInAsSb solid solution disposed on the substrate.

In an embodiment of the light emitting diode, the first contact is configured continuous, and the second contact is configured to have a partially covered surface.

In an embodiment of the light emitting diode, the second contact is configured in ring-shaped. In an embodiment of the light emitting diode, the first contact contains a Cr/(Au+Zn)/Ni/Au four-layer system, and the second contact contains a Cr/(Au+Te)/Ni/Au four-layer system. Further, according to the third aspect of the present invention, the object is achieved by providing a light-emitting diode (LED) for a mid-IR spectral range, the LED comprising: at least one LED chip which is configured on the basis of the heterostructure according to the first aspect of the present invention and which comprises at least one contact connected to the contact layer and at least one contact connected to the substrate on the active layer side. According to the fourth aspect of the invention, the object is achieved by providing a method of producing the light emitting diode according to the third aspect of the present invention, the method including: providing a heterostructure according to the first aspect of the present invention, reducing the thickness of the substrate, forming the first contact on the heterostructure on the active layer side, forming the second contact on the heterostructure on the substrate side; and splitting the heterostructure with the contacts formed thereon to form LED chips.

Further, according to the fourth aspect of the present invention, the object is achieved by providing a method of producing the light emitting diode according to the third aspect of the present invention, the method including: providing the heterostructure according to the first aspect of the present invention; forming a first contact connected to the contact layer on the heterostructure on the active layer side; forming the second contact connected to the substrate on the heterostructure on the active layer side; reducing the thickness of the substrate; and splitting the heterostructure with the contacts formed thereon to form LED chips.

### TECHNICAL EFFECT

The heterostructure being introduced with a buffer layer comprising a GaInAsSb solid solution with an indium (In) less than the active layer and with a corresponding level of doping, makes it possible to achieve a technical effect, which is characterized in that, owing to the minor carries being localized in the active region, an amount of radiative recombination increases and, hence, the quantum efficiency of the heterostructure increases accordingly as per the present invention. Further, use of the buffer layer minimizes the influence of defects penetrating from the substrate into the active region, thereby resulting in reduced deep acceptor levels and, accordingly, in a reduced amount of non-radiative Shockley-Read-Hall recombination, and in a subsequent increase in the quantum efficiency of the heterostructure. Furthermore, a heterostructure having an arrangement according to the present invention has the current-voltage characteristic enabling an light-emitting diode (LED) to perform at small currents, because, unlike the known thyristor-type structure, it exhibits no hysteresis. Moreover, owing to its reliability and consistent performance, the claimed heterostructure is not susceptible to breakdowns at high currents. A further advantage is that growing the heterostructure does not require an n-GaSb-containing buffer layer to be grown from a lead-containing solution-melt; therefore, the provided growing technique represents a simpler technology, which is environmentally friendly and safe for the personnel.

### BRIEF DESCRIPTION OF THE DRAWINGS

Fig. 1 is a schematic energy diagram of a thyristor-type light emitting diode structure known from the prior art;
Fig. 2 is the current-voltage characteristic of a thyristor-type light emitting diode structure known from the prior art;
Fig. 3 is a schematic embodiment of the heterostructure having one-sided limiting of carriers according to the present invention;
Fig. 4 is a schematic energy diagram of a heterostructure embodiment, having a reverse p-n junction, emitting at a wavelength of 1.85 µm;
Fig. 5 is a schematic energy diagram of another heterostructure embodiment, having a reverse p-n junction, emitting at a wavelength of 2.05 µm;
Fig. 6 is a schematic energy diagram of another heterostructure embodiment, having a reverse p-n junction, emitting at a wavelength of 2.2 µm;
Fig. 7 represents current-voltage characteristics of light emitting diodes based on the heterostructures depicted in Figs. 4 - 6;
Fig. 8 is a schematic view of a cartridge for liquid-phase epitaxy;
Fig. 9 is a schematic illustration of a light emitting diode structure of a spectral range of 1.8-2.4 µm;
Fig. 10 is a flowchart of the method of producing an light-emitting diode (LED) of the spectral band of 1.8-2.4 µm.

Embodiments of the present invention will now be described below, with reference to the accompanying drawings. The presented embodiments are illustrative examples of the present invention, which, however, should not to be deemed as limiting the scope of the claimed invention. The scope of the present invention is defined and limited in the claims herein.

### DETAILED DESCRIPTION OF THE INVENTION

Major factors limiting the inner quantum yield of GaSb-based heterostructures, with radiation at a wavelength within the spectral range of 1.8-2.4 µm, are the lack of barrier to minor carriers and the presence of deep acceptor levels correlated with the defects growing from the substrate. A wide-band AlGaAsSb confining layer containing over 30% of aluminum provides a very good localization of electrons in the active region. However, such layers do not provide hole confinement, because at the IGaAsSb/GaInAsSb heteroboundary, at which the percentage of indium (In) is 5-20%, there is no discontinuity in the valence band. Leakage of holes from the active region prevents from having a high probability of the radiative recombination process.

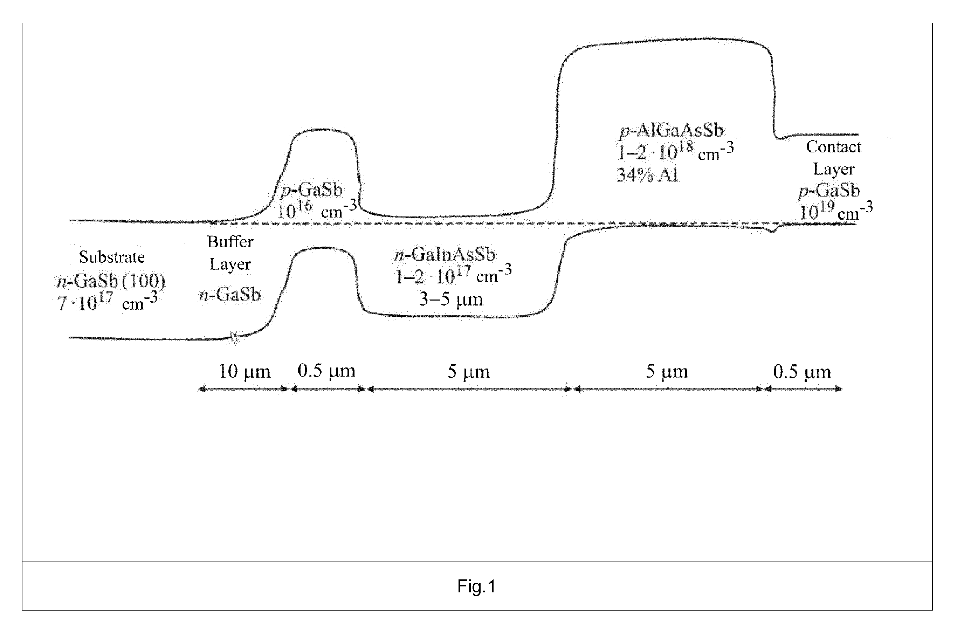

Figure 1 displays an energy diagram of the known light-emitting diode (LED) structure of a thyristor type. This known heterostructure comprises an n-GaSb-containing buffer layer, and a built-in p-GaSb-containing layer disposed between said buffer layer and an active layer. The buffer layer in this heterostructure prevents from defects penetrating from the substrate, with the built-in layer providing confinement of holes in the active region in the vicinity of the p-GaSb/n-GaInAsSb heteroboundary.

Growing a GaSb-containing buffer layer, which is of sufficient thickness (over 1.5 µm) and has a high structural perfection and a low concentration of carriers, brings appreciable technological difficulties. The difficulties are primarily associated with the metallurgical features of gallium antimonide. Unlike other semiconductor compounds of A³B⁵, such as GaAs, GaP, InP, InAs, the regularly grown crystals and layers of a GaSb binary compound and the GaSb-based solid solutions are featured with a high concentration of intrinsic defects which cause a high intrinsic-carrier concentration in undoped layers, and, furthermore, are characterized with a great concentration of the deep acceptor levels in the band gap. The n-GaSb-containing buffer layer of the known heterostructure is reported to be grown from a solution-melt containing lead as a neutral solvent. This process reduces the concentration of structural defects in the buffer layer. However, as described above, using lead impairs the environmental compatibility of the process and also determines the processing complexity; and, furthermore, the thyristor-type current-voltage characteristic, specific of the heterostructure, limits its applicability.

Moreover, during the epitaxial growth of the heterostructure, its crystal lattice may be introduced with defects caused by the differences in the chemical compositions of the materials constituting its layers. In the course of the epitaxial growth, going from layer to layer, atoms of one element may be substituted with atoms of another element, and one of the constituent elements may be excluded from the material composition or else included in the composition, which may cause mechanical strains due to a mismatch between the crystal lattice constants. These strains are the cause for a variety of defects - point defects, dislocations, microcracks, etc., occurring in the LED heterostructure. These defects have a negative impact on the radiation efficiency in heterostructures.

A mismatch of lattice constants not exceeding 0.5% is allowable for LEDs operation. In order to make LEDs functional in the 1.8-2.4 µm spectral range, semiconductor materials have to be used, which have a width E_{g} of the band gap of 0.7-0.55 eV. Of the compounds A³B⁵, there is one binary compound functional in this range: GaSb (E_{g}=0,72 eV, T=300 K) and various ternary and InAs-GaSb quaternary solid solutions. Because of the matching lattice constants, the binary compounds-based heterostructures have no misfit dislocations on the layer/substrate boundary. They are structurally perfect but are only suitable for covering discrete segments of the spectral range. Besides, in the event that a GaSb compound is used, there tend to appear the technology difficulties described above. Turning over to the ternary solid solutions makes it possible to cover a wider spectral range. Quaternary solid solutions allow obtaining any match of the lattice constants to the substrate and have a sufficiently large range of band gap variation.

A light emitting diode heterostructure according to the present invention comprises a plurality of layers of a semiconductor material of a variable composition, the plurality of layers grown on a substrate from a GaSb binary compound. Radiation is generated in the active region, with the required wavelength being determined by the composition of the material used and by the active layer growing conditions.

A GaInAsSb quaternary solid solution forms matches for many compositions lattice-matched to the GaSb substrate. Over the entire range of the compositions, these materials are direct band semiconductors and are suitable for creating both type II staggered and straddling heterojunctions, depending on the composition.

The present invention discloses a heterostructure comprising a low-doped buffer layer p⁰ with a composition approaching that of GaSb, which makes it possible that a reverse p-n junction p⁰-GaInAsSb/n-GaInAsSb ensures confinement of holes within the active region in the vicinity of the heteroboundary between the buffer layer and the active layer. Besides, growing a structurally perfect layer of p⁰-GaInAsSb, which has a minimum concentration of impurities and defects, ensures a minimum negative impact from defects penetrating from the substrate into the active layer, which results in a decrease in the deep acceptor levels and, accordingly, in the reduction of Shockley-Read-Hall non-radiative recombination. Moreover, because the claimed heterostructure is grown at a low level of doping the buffer layer p⁰, i.e., at the doping level approaching the intrinsic density, a substantial increase in quantum efficiency of the heterostructure is thus obtained, with the forward voltage of the heterostructure showing only a slight increase, rather than being a number of times greater, as observed for the structures of thyristor type. In addition, the process of growing such buffer layer according to the present invention does not involve using lead as a neutral solvent.

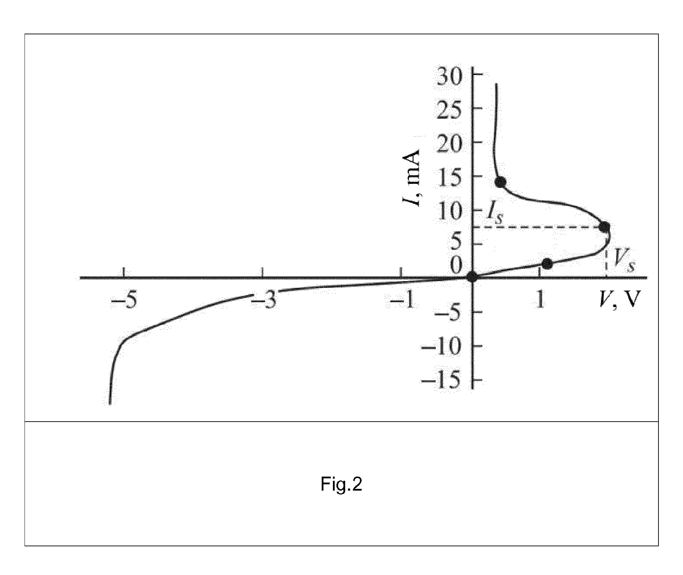

Figure 2 shows a current-voltage characteristic of the known light-emitting diode (LED) structure of thyristor type from Fig. 1. The S-shaped current-voltage characteristic has a form which is typical for thyristor structures. A breakover voltage V_{S} of the known heterostructure amounts to 1.9 V, with the turn-on current I_{S} of 7.5 mA. In the turn-on condition, the voltage drops abruptly down to 0.45 V.

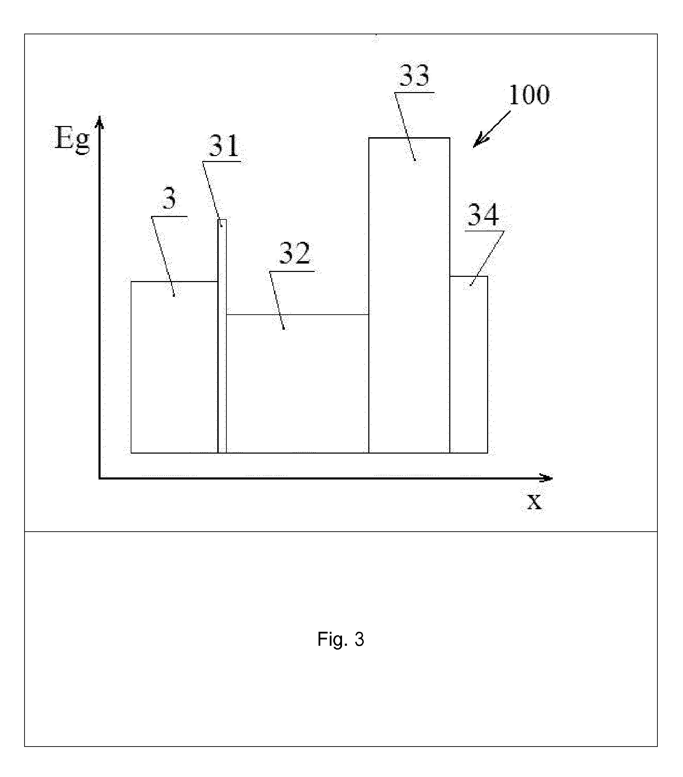

Figure 3 displays a schematic embodiment of the claimed heterostructure n-GaSb/p⁰-GaInAsSb /n-GaInAsSb/p-AlGaAsSb/p-GaSb, with one-sided limiting of carriers according to the present invention. Thickness of each layer is schematically shown along the axis x; while along the axis *E_{g}*, the band gap width is schematically plotted. A heterostructure 100 comprises an n-GaSb-containing substrate 3, a buffer layer 31 which contains a GaInAsSb solid solution and which is disposed over the substrate, an active layer 32 which contains a GaInAsSb solid solution and which is disposed on the buffer layer, a confining layer 33 which contains a AlGaAsSb solid solution and which is disposed on the active layer, and a contact layer 34 which contains GaSb and which is disposed on the confining layer. The substrate 3 being 150-280 µm in thickness contains tellurium and has a free carrier concentration of 3-5*10¹⁷ cm⁻³. The buffer layer 31 is configured with indium (In) content in the range of 1.2-1.6 % with a high structural perfection and an intrinsic density of holes less than 10¹⁶ cm⁻³ and has a thickness of 0.5-15 µm. The active layer is configured with indium (In) content in the range of 4-25 % and is tellurium-doped to reach an intrinsic density of electrons at least 10¹⁷ cm⁻³ and has a thickness ranging between 1-15 µm. The wide-band confining layer 33 is configured having an aluminum in the range of 30-65 % and is germanium-doped to reach a hole concentration at least 10¹⁸ cm⁻³ and has a thickness in the range of 0.5-10 µm. The contact layer 34 is configured to provide connection and interaction with the lower contact in the process of LED production and has a thickness in the range of 0.5-8 µm. Parameters of the buffer layer 31 are selected depending on the characteristics of the subsequent active layer 32. The buffer layer has a low hole concentration (p<10¹⁶cm⁻³), which provides a potential barrier for the holes at the buffer layer/active region heteroboundary, with the diode nature of the current-voltage characteristic retained.

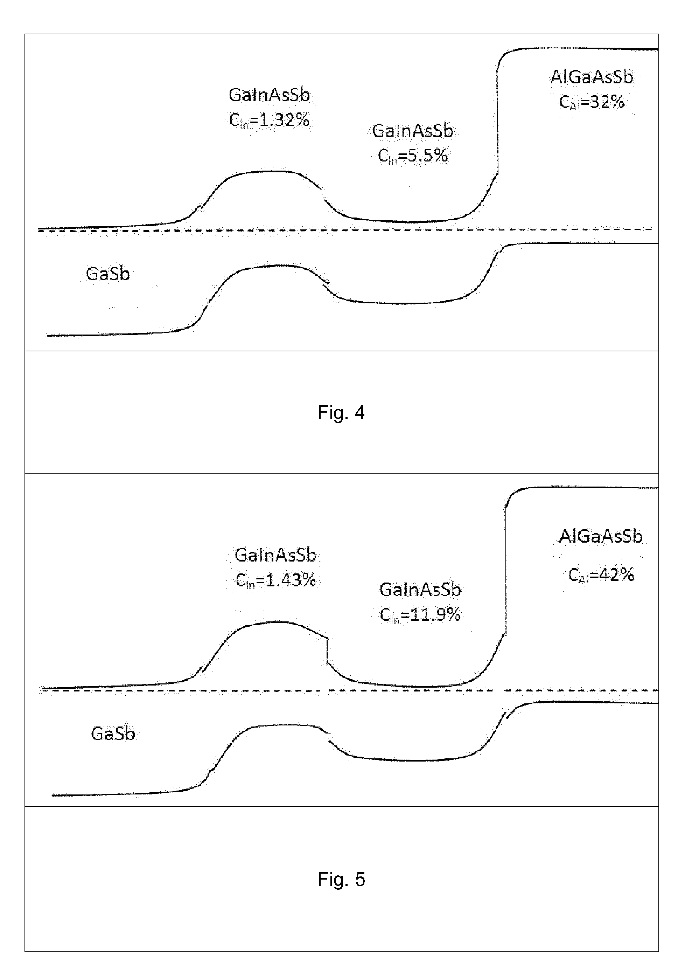

Figure 4 displays an energy diagram of an embodiment of the heterostructure with a reverse p-n junction, emitting at a wavelength of 1.85 µm. The maximum in the spectrum of LEDs, which are based on the heterostructures as per the present invention, is determined by the percentage of indium (In) in the composition of a GaInAsSb quaternary solid solution in the active layer 32. Therefore, when the active layer 32 is configured to contain 5.5% of indium (In), the heterostructure 100 is emitting at a wavelength of 1.85 µm.

Figure 5 demonstrates an energy diagram of another embodiment of the heterostructure with a reverse p-n junction, emitting at a wavelength of 2.05 µm. The active layer 32 of the heterostructure 100 is configured to contain indium (In) at 11.9%.

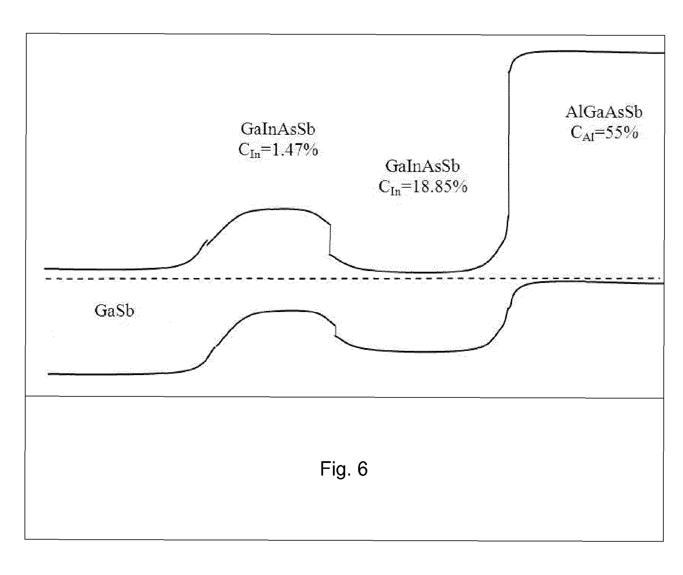

Figure 6 demonstrates an energy diagram of yet another embodiment of the heterostructure with a reverse p-n junction, emitting at a wavelength of 2.2 µm. The active layer 32 of the heterostructure 100 is configured to contain indium (In) at 18.85%.

Therefore, according to the present invention, depending on the indium (In) content in the active layer 32, a heterostructure may be obtained, which is emitting at any required wavelength within the range 1.8- 2.4 µm.

Moreover, a heterostructure according to the present invention is not limited with the use of indicated substances as dopants; and any other dopants may be applied, which are capable of providing the required density of carriers in the layer.

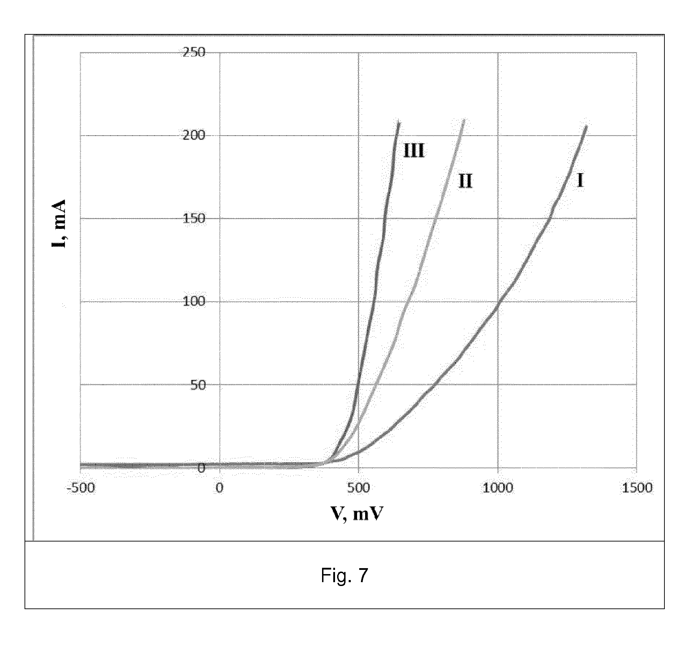

Figure 7 displays current-volttage characteristics of the heterostructures shown in Figs. 4-6: (I) designates the current-voltage curve plotted for a diode based on the heterostructure with a reverse p-n junction, emitting at a wavelength of 1.85 µm; designated with (II) is the current-voltage curve for a wavelength of 2.05 µm; and (III) designates the current-voltage curve for a wavelength of 2.2 µm. As seen from Fig. 7, the current-voltage curves have the shape of diode characteristics, unlike the current-voltage characteristic of the known heterostructure shown in Fig. 2. Therefore, the heterostructures according to the present invention are to avoid the above-indicated disadvantages of the known heterostructure of thyristor type.

According to the present invention, a heterostructure is produced by a process using liquid-phase epitaxy. Besides, a person skilled in the art may produce the provided heterostructure using any equipment suitable for liquid-phase epitaxy. It should be noted that the provided process is not limited with liquid-phase epitaxy only: the provided heterostructure may be produced using the techniques of molecular-beam epitaxy, gaseous-phase epitaxy; in particular, chlorine-hydride vapor-phase epitaxy, chlorine vapor-phase epitaxy, or any other process suitable for obtaining a heterostructure that has the structure according to the present invention.

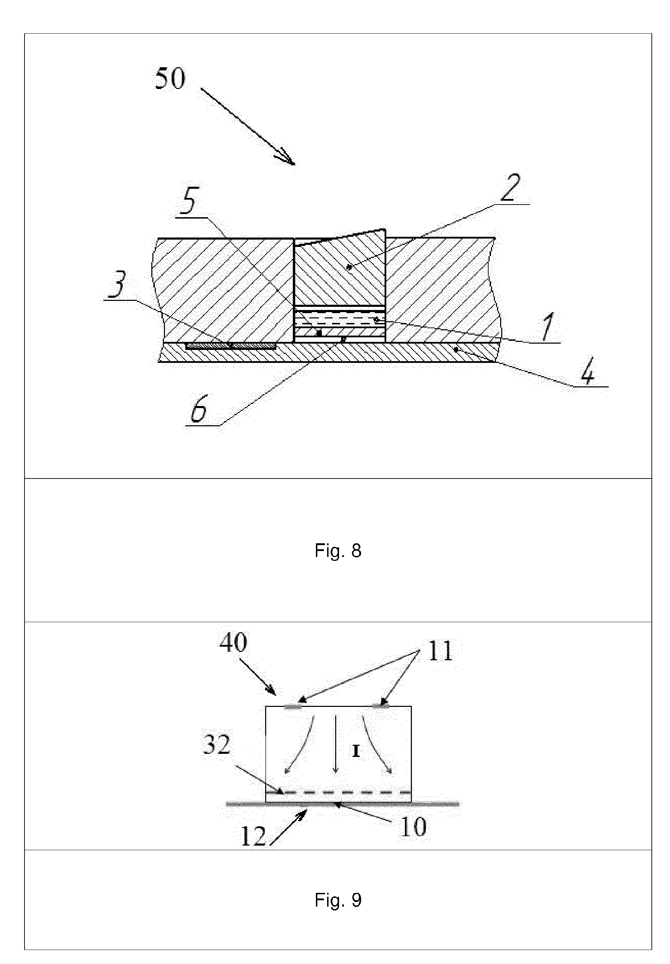

Figure 8 displays a schematic view of a cartridge 50 for a liquid-phase epitaxy. The cartridge 50 comprises a piston 2, a growth chamber 6, channels 5 for filtering the melt 1, and a slide 4 for moving a substrate 3.

The process for producing a heterostructure by a liquid phase epitaxy involves preliminary stages and layer-growing stages. At a preliminary stage, the substrate and the materials to be used for growing layers are etch-cleaned, using etches specifically tailored for each of the materials, are washed, and dried. Thus processed mix materials are loaded onto a graphite cartridge 50, are covered with a piston, and then the loaded cartridge is disposed into a reactor of the liquid-phase epitaxy furnace. The processed substrate 3 is disposed over a slide 4. Then the reactor is evacuated down to a residual pressure of not greater than 1*10⁻² mm Hg. Then the reactor is filled with hydrogen and is then blown off. Upon blowing off, the system is heated using a heater up to a homogenization temperature and is held at this temperature. Then the system is cooled down, and once the epitaxy temperature is reached, the melt 1 is pressed with the piston 2 through the narrow channels 5 into the growth chamber 6, under which the substrate is moved in thus realizing epitaxial growth of one layer. Further, using the slide 4, the substrate is taken out of the growth chamber 6; the heater is shifted off the reactor, and the system is cooled down to room temperature. Then, using the slide 4, the substrate 3 is moved into the next growth chamber 6 to grow the next layer.

To grow the GaInAsSb-containing buffer layer and active layer, the material mix may contain binary compounds of InAs, GaSb, InSb, as well as elementary indium (In) and stibium at a purity of 99.999 wt.%, and doping elements. There are a number of techniques available for obtaining GaInAsSb solid solutions, which are isoperiodic to GaSb; and these techniques differ in the way arsenic is introduced into the melt: either from a quantity of InAs or GaAs weighted out exactly in accordance with the phase diagram, considering the conditions for matching the lattice constants in the structures and on the GaSb substrate, or from a GaAs single-crystal substrate being in contact with the melt. The process of producing heterostructure according to the present invention is not limited with the above specified ways of introducing arsenic, and arsenic may be introduced into the melt using any other suitable process known in the epitaxy field.

A two-phase process is given as an example. Advantageously, this process is characterized with a high reproducibility. Arsenic is introduced from a GaAs saturating substrate for saturating the melt with arsenic. The size of saturating substrate may be selected as 1x1 cm². Such saturating substrate is used to cover the material mix in a cell of the cartridge 50. Thermodynamic properties of such system differ considerably from the properties of the liquid phase taken separately. Arsenic content in the melt, which is in contact with the GaAs substrate, is practically independent of the stibium content and is approaching the maximum possible concentration at a given temperature, because of the liquid phase composition stabilization effect. Using this method makes it possible to reproducibly obtain epitaxial layers of GaInAsSb solid solutions, which are isoperiodic to GaSb.

After growing the buffer layer 31 on the substrate 3, the substrate 3 with the buffer layer 31 is moved over to the next growing chamber 6, wherein the active layer 32 is grown on the buffer layer 31.

Growing time, required to obtain a layer of a certain thickness, may be determined experimentally. When liquid-phase epitaxy equipment is capable of controlling the thickness of a layer and, accordingly, the growing time by using any known means, the experimentally determined growing time may be taken as a preliminary reference.

After growing the active layer 32, a confining layer 33 is grown thereon, which contains AlGaAsSb and is intended as a confining wide-band region of the diode to localize major carriers.

To obtain AlGaAsSb solid solutions, which are isoperiodic to GaSb substrate, the following is to be carried out: A starting material mix containing Al, GaSb and doping mixture, is disposed in a piston chamber of a cartridge 50. Then, over the material mix, a quantity of liquid gallium is poured, upon which an etched GaAs substrate is disposed. The material mix and the etched substrate disposed over it are covered with a piston 2. A substrate 3, with a buffer layer and an active layer grown thereon, is disposed on a slide 4. The system is then heated up in hydrogen atmosphere and is kept for a few hours for homogenization. Then cooling is performed. Because the GaAs substrate is kept in the melt all the time, provided that the layer of melt in the piston chamber is thin and the cooling rate is low, excess arsenic is all deposited on the substrate during cooling in the form of a thin layer of solid solution, which composition approaches that of Al-As and its content in the melt is always close to the maximum possible concentration at a given temperature. Once the epitaxy temperature is attained, the melt is pressed with the piston 2 through the narrow channels 5 into the growth chamber 6, under which the substrate is moved in, and epitaxial growth of the confining layer 33 is realized. The melts are subjected to filtering in order to clean oxides off.

Further, a GaSb-containing contact layer 34 is grown on the confining layer 33. The material mix used for growing the contact layer 34 may contain GaSb and doping agents.

For a heterostructure according to the present invention, the grown layers each have a thickness determined in accordance with the heterostructure's design.

Figure 9 shows the structure of an light-emitting diode (LED) 40 intended for the spectral range 1.8-2.4 µm, configured on the basis of any heterostructure of the embodiments according to the present invention.

The LED 40 comprises a heterostructure 100, an active layer 32 shown with a dash line in Fig. 9, an upper contact 11 configured on the side of a substrate 3, and a lower contact 12 configured on the side of the active layer 32. On the side of the lower contact 12, the LED 40 is attached to a housing 10. In this embodiment, the upper contact 11 is configured to take a shape of a ring.

The light-emitting diodes (LEDs) may find application in metrology, which imposes specifically stringent requirements to reliability and consistency of LED operation. The structure of the presented LED reduces Joule heating in the active region due to the flowing current. The provided structure provides a uniform spreading of current over the entire area of the p-n junction and creates a very low thermal resistance, because the active layer 32 is disposed at a distance of 1 to 5 µm, preferably, 2 µm, from the housing 10 of the LED 40. Despite that in the given example of LED 40 the upper contact is configured in the shape of a ring, the upper contact may also be made as a frame of a rectangular, oval, or any other shape, as dots, crosses, or any solid geometry form, without going beyond the scope of the present invention.

Further, in another LED embodiment of the present invention, the upper contact may be configured on the active layer side, and the lower contact may be configured on the substrate side.

Moreover, based on the heterostructure according to the present invention, an LED may be produced having contacts for flip-chip joining.

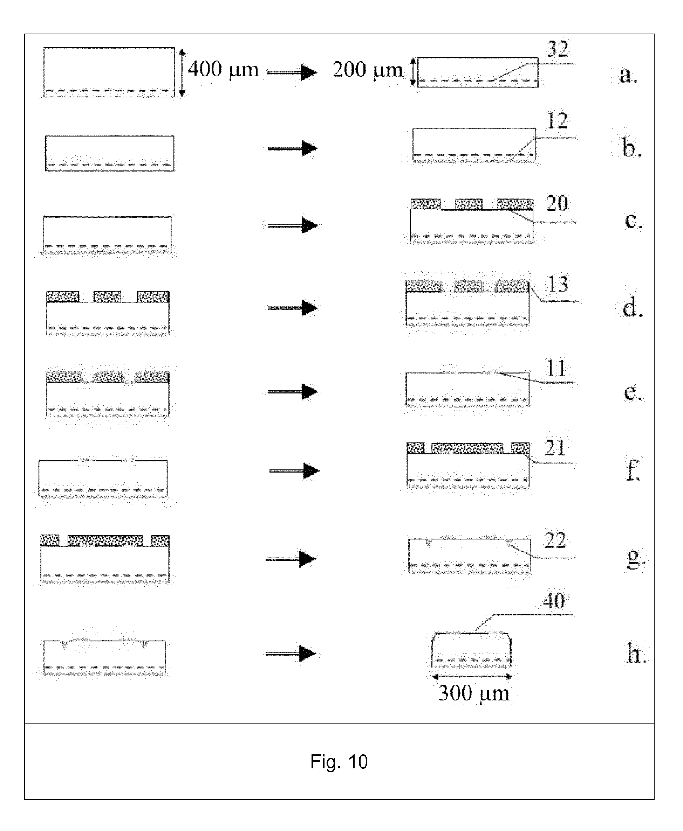

Figure 10 is an example of a flowchart displaying the sequence of stages for the process of producing an LED for the spectral range of 1.8-2.4 µm. Apart from this, in order to production the specified light emitting diodes, other processes known from prior art may be applied. The technology process for manufacturing discrete LEDs for the spectral range of 1.8-2.4 µm comprises the following stages.

At the first stage, the heterostructure substrate is thinned to a required thickness, e.g. 200 µm, by grinding or using a chemical polish. The first stage is shown in Fig. 10(a), with an active layer 32 shown as a dash line.

At the second stage illustrated in Fig 10(b), on the active layer side, continuous deposition of a lower contact 12 is performed on a contact layer 34. On the contact p-layer 34, a continuous contact is deposited, comprising a four-layer system of Cr/(Au+Zn)/Ni/Au. An adhesive layer of Cr is deposited to a thickness of 200 Å to improve adhesion on the substrate. The contact layer of the lower contact is an alloy of gold and zinc, with zinc content of, say, 4.4 %, at a thickness of 0.1 µm; and during the subsequent firing of the contacts, an eutectic mixture with the substrate material is formed, which provides a low ohmic resistance of the contact. Then a layer of nickel is deposited to form a barrier layer of 0.1 µm in thickness. Over the nickel layer, a 0.15 µm-thick layer of gold with a purity of 99.99% is deposited. Without a barrier layer, the entire layer of gold forms a eutectic with the substrate material during firing, which prevents soldering or welding to the contact. Nickel prevents diffusion of gold from the upper layer and helps to maintain a good quality golden coating. Subsequent deposition of all the metals is carried out within a single process, with a vacuum in a deposition chamber being maintained at least at 10⁻⁶ mm Hg. Once a vacuum of 10⁻⁶ mm Hg is attained, which is necessary for thermal vacuum deposition, a table is heated up, with a heterostructure disposed thereon.

At the third stage illustrated in Fig. 10(c), photolithography is performed to make a window for the upper contacts on the substrate side. A photoresist 20 is applied. A photomask with contact configuration, e.g., configured as a ring of 200 µm and with a step of 350 µm is aligned with a semiconductor wafer. Exposure is determined by experiment, and the exposure time amounts to, for example, from 20 to 90 seconds, depending on the size of the components and the thickness of the photoresist 20. Removal of the exposed parts of the photoresist 20 is carried out in a 1% solution of potassium hydroxide KOH. The remaining photoresist in the structure is subjected to hardening: a heat treatment for 60 min at 80°C-120°C. After hardening, the samples are etched using an anisotropic etching solution. Any other substances suitable for use with a specific photoresist and not affecting the heterostructure's layers may be used instead of KOH developer.

At the fourth stage illustrated in Fig. 10(d), deposition of a metal system 13 is carried out, to obtain an upper contact 11. To form ohmic contacts 11, the next four-layer system Cr/(Au+Te)/Ni/Au is deposited on a substrate 3 partially coated with a photoresis 20. Similarly to the lower contact, the upper contact comprises a Cr-containing adhesive layer, a contact layer, a Ni-containing barrier layer, and a layer of gold. The contact layer of the upper contact is an alloy of gold and tellurium, with tellurium content of 5 % at a thickness of 0.1 µm, and during the subsequent firing of the contacts, a eutectic mixture with the substrate material is formed, which provides a low ohmic resistance of the contact. Deposition is carried out similarly to the second stage deposition illustrated in Fig. 10(b). The difference is that the upper layer of gold is additionally grown using a galvanic technique to a thickness of 1.5 µm. Such a thickness of the golden layer is required to weld wire into the light-emitting diode (LED) chip by means of thermal compression, ultrasound welding, or bead welding, etc.

Immediately prior to deposition, the samples are immersed into a 23% solution of hydrofluoric acid for a few seconds to remove anodic oxides from the deposition spots with a purpose of extra cleaning of the surface, and then washed in deionized water. Subsequent deposition of all the metals is carried out as a single process at a vacuum maintained in the deposition chamber at a level of at least 10⁻⁶ mm Hg. Once a vacuum of 10⁻⁶ mm Hg is attained, which is required to carry on thermal vacuum deposition, a table is heated up, with the heterostructure disposed thereon, to a temperature not exceeding 150°C, because the majority of positive photoresists are thermoplastic polymers characterized with a low glass-transition temperature (T_{g} amounts to 50-125°C). Heating the table lasts for 30 minutes. As this occurs, a high vacuum (10⁻⁶ mm Hg) is maintained to remove residual gases and to carry out additional degassing of the photoresist film. After switching off the heating of the table, the working chamber is evacuated to maintain a high vacuum until the table is cooled down completely.

At the fifth stage illustrated in Fig. 10(e), the photoresist 20 is removed. The photoresist 20 is removed from the surface of the structure using an explosive stripping technique, for instance, by immersing into monoethanolamine; after which the structure is thoroughly washed in distilled water. On the surface on the substrate 3 side, after removal of the photoresist 20, there only the contact 11 remains, which is a deposited metal in the form of bumps of a predetermined diameter. Additionally, without departing from the scope of the present invention, photoresist may be removed using other stripping techniques known from prior art, for example, by means of dry etching with the use of extra photolithography.

At the sixth stage (not shown in Fig. 10) firing of contacts is realized in order to obtain low ohmic resistance. After deposition and explosive photolithography the samples are baked in order to fuse an ohmic contact. Baking is carried out for 1-2 minutes at a temperature of 250°C to 400°C, depending on the semiconductor material, in hydrogen flux in a quartz chamber.

At the seventh stage illustrated in Fig. 10(f), photolithography is carried out to form a separating grid. Thus, a pattern is created on the surface, which facilitates splitting the structure into separate chips. Photoresist 21 is applied on the substrate from the substrate side and the contact 11 is disposed thereon. Using alignment marks, the pattern on the mask is aligned with the pattern on the structure obtained during the first photolithography. Resist exposure is carried out; then the exposed photoresist is removed, and the remaining parts of the photoresist 21 are hardened similarly to photolithography at the third stage.

At the eighths stage illustrated in Fig. 10(g), etching the separating grid 22 is carried out. To split the wafers into chips, mask etching is applied, which mask is applied on a crystal using photolithography. To create the separating grid, liquid etching is performed. A cartridge with a sample is immersed into a polishing etch. The cartridge with a sample is then taken out of the polishing etch after a certain period of time. During etching, mixing is carried out by steady rotation of the cartridge at regular intervals. After etching, the sample is washed with distilled water. Then the remaining photoresist is stripped. It should be noted that washing at the photoresist stripping stages may also be carried out in deionized water. Furthermore, etching may be carried out using not only liquid etching but also known methods of dry etching may be applied, such as plasma etching or other methods.

At the ninth stage illustrated in Fig. 10(h), upon etching the separating grid 22, the LED wafer is split into discrete chips 40 using diamond cutting or cleavage. As an example, Fig. 10(h) illustrates a chip 40, which may have a longitudinal dimension of 300 µm.

After discrete chips 40 have been produced, an assembly stage is to be carried out. A light-emitting diode (LED) chip 40 is soldered to the surface of a housing, for example, TO-18, using a tin-based solder. The housing is mounted on a heated table of a bonder. The solder is applied as a thin layer on the housing surface. Using a manipulator, an LED chip 20 is mounted in the center of the housing, with the continuous contact 12 placed face down. Heating is switched on. The chip 40 is pressed down, and then the heating temperature is decreased down to room temperature. Further, the upper contact 11 is welded or soldered to LED chip 40. The upper contact 11 of LED chip is connected to an insulated stem of the TO-18 housing using a golden wire of 20÷30 µm in diameter. Connecting wire to the chip contact may be carried out using at least one of the following: low-temperature soldering with a tin-containing solder, ultrasound welding, or bead welding. Furthermore, assembling operation may be carried out using other technology known from prior art.

When an LED is produced with contacts for flip-chip configuration, the contact to the active region and the contact to the substrate are configured from below so that the top surface of the heterostructure remains clear. To produce an LED according to the present invention, other processes may be applied known in the flip-chip technology.

LEDs according to the present invention are operative at room temperature. Furthermore, if a predetermined temperature is to be maintained either above or below room temperature, the LEDs comprise at least one Peltier element.

Such LED works as follows. Once a forward voltage is applied - with the positive end connected to the contact layer and the negative end connected to the n-type substrate - the electric current is flowing through the heterostructure. Electrons from the substrate are injected through the buffer layer into the active region. A high potential barrier from the AlGaAsSb confining layer limits their flow to the positive contact. Holes from the p-type confining layer are injected into the active region. Their leakage towards the negative contact is limited with the potential barrier at the buffer layer/ active region boundary. Being confined within the active region, electrons and holes recombine efficiently, with the infrared radiation being emitted at a wavelength corresponding to the band gap width of the active region. IR radiation passes through the substrate at a minimum loss, because the substrate material is not absorbing radiation in the spectral band of 1.8-2.4 µm, and comes out on the substrate side in the region not covered with the contact 11.

It should be noted that the embodiments of the present invention described in the specification are illustrative examples only, which, however, should not to be deemed as limiting the scope of the invention. The scope of the present invention is defined in its entirety in the following claims.

## Claims

1. A heterostructure based on a GaInAsSb solid solution, the heterostructure comprising:
a substrate containing GaSb;
an active layer which contains a GaInAsSb solid solution and which is disposed over the substrate;
a confining layer for localizing major carriers, the confining layer containing a AlGaAsSb solid solution and being disposed over the active layer;
a contact layer containing GaSb, and the contact layer being disposed over the confining layer;
**characterized in that** the heterostructure comprises
a buffer layer which contains a GaInAsSb solid solution and which is disposed between the substrate and the active layer, wherein the buffer layer contains indium (In) less than the active layer.

2. The heterostructure of Claim 1, wherein a mole fraction of indium (In) among the elements of the group III in the buffer layer is 1.2-1.6 %.

3. A method of producing a heterostructure based on a GaInAsSb solid solution, the method including:
growing, by a liquid-phase epitaxy technique, a p-type buffer layer on an n-type GaSb substrate, the buffer layer containing a GaInAsSb solid solution;
growing, by a liquid-phase epitaxy technique, an n-type active layer on the buffer layer, the active layer containing a GaInAsSb solid solution, so that the active layer contains indium (In) more than the buffer layer;
growing, by a liquid-phase epitaxy technique, a p-type confining layer for localizing major carriers on the active layer, the confining layer containing a AlGaAsSb solid solution;
growing, by a liquid-phase epitaxy technique, a p-type contact layer containing GaSb on the confining layer.

4. A light-emitting diode for a mid-infrared spectral range, the light-emitting diode comprising:
at least one light-emitting diode (LED) chip which is configured on the basis of the heterostructure according to any one of claims 1-2 and which comprises a first contact configured on the active layer side and a second contact configured on the substrate side,
**characterized in that**
the LED chip comprises a buffer layer containing a GaInAsSb solid solution disposed on the substrate.

5. The light-emitting diode of claim 4, wherein the first contact is configured continuous, and the second contact is configured to have a partially covered surface.

6. The light-emitting diode of claim 4 or claim 5, wherein the second contact is ring-shaped.

7. The light-emitting diode according to any one of claims 4-6, wherein the first contact contains a Cr/(Au+Zn)/Ni/Au four-layer system, and the second contact contains a Cr/(Au+Te)/Ni/Au four-layer system.

8. A method of producing the light-emitting diode according to any one of claims 4-7, the method including:
providing the heterostructure according to any one of claims 1-2;
reducing the thickness of the substrate;
forming the first contact on the heterostructure on the active layer side;
forming the second contact on the heterostructure on the substrate side;
splitting the heterostructure with the contacts formed thereon to form light-emitting diode (LED) chips.

9. A light-emitting diode for a mid-infrared spectral range, the light-emitting diode containing at least one light-emitting diode (LED) chip which is configured on the basis of the heterostructure according to any one of claims 1-2 and which comprises at least one contact connected to the contact layer and at least one contact connected to the substrate on the active layer side.

10. A method of producing the light-emitting diode of claim 9, the method including:
providing the heterostructure according to any one of claims 1-2,
forming the first contact connected to the contact layer on the heterostructure on the active layer side;
forming the second contact connected to the substrate on the heterostructure on the substrate side;
reducing the thickness of the substrate;
splitting the heterostructure with the contacts formed thereon to form LED chips.
